(19) Europäisches Patentamt
European Patent Office
Office européen des brevets

(11) Veröffentlichungsnummer: **0 331 965 A2**

(12) # EUROPÄISCHE PATENTANMELDUNG

(21) Anmeldenummer: 89102965.4

(22) Anmeldetag: 21.02.89

(51) Int. Cl.4: C08K 3/40 , C08K 5/04 , C08L 81/02 , //(C08L81/02, 69:00,83:04)

(30) Priorität: 05.03.88 DE 3807231
14.01.89 DE 3901029
06.01.89 DE 3900260

(43) Veröffentlichungstag der Anmeldung: 13.09.89 Patentblatt 89/37

(84) Benannte Vertragsstaaten: BE DE FR GB IT NL

(71) Anmelder: BAYER AG
D-5090 Leverkusen 1 Bayerwerk(DE)

(72) Erfinder: Wehnert, Wolfgang, Dr.
Bodelschwinghstrasse 14
D-4150 Krefeld 1(DE)
Erfinder: Reinking, Klaus, Dr.
Robert-Stolz-Strasse 16 b
D-5632 Wermelskirchen 1(DE)
Erfinder: Tresper, Erhard, Dr.
Moerser Strasse 394
D-4150 Krefeld 11(DE)
Erfinder: Köhler, Karl-Heinz, Dr.
Buschstrasse 165
D-4150 Krefeld 1(DE)
Erfinder: Traenckner, Hans-Joachim, Dr.
Wedelstrasse 46
D-4150 Krefeld(DE)
Erfinder: Schmidt, Manfred, Dr.
Erich-Klausener-Strasse 37
D-4150 Krefeld 1(DE)

(54) **Mischungen aus Polyarylensulfiden, organischen Carbonaten, weiteren Thermoplasten und Glasfasern.**

(57) Die Erfindung betrifft Mischungen aus Polyarylensulfiden, vorzugsweise Polyphenylensulfid (PPS), organischen Carbonaten, weiteren Thermoplasten und Glasfasern.

EP 0 331 965 A2

Xerox Copy Centre

## Mischungen aus Polyarylensulfiden, organischen Carbonaten, weiteren Thermoplasten und Glasfasern

Die Erfindung betrifft Mischungen aus Polyarylensulfiden, vorzugsweise Polyphenylensulfid (PPS), organischen Carbonaten, weiteren Thermoplasten und Glasfasern.

Polyarylensulfide und ihre Herstellung, sowie deren Abmischungen mit verschiedenen Zusatzstoffen sind bekannt (z.B. US-A-3 354 129, EP-A-171 021) und handelsüblich.

Unverstärktes PPS hat unbefriedigende mechanische Eigenschaften für Anwendungen im Spritzgußbereich, insbesondere sind Biege- oder Zugfestigkeit und Elastizitätsmodul für die Praxis häufig nicht ausreichend. Es hat sich daher als von Vorteil erwiesen, PPS z.B. durch Verstärkung mit Glasfasern oder durch Abmischung mit anderen Thermoplasten in den genannten Eigenschaften zu verbessern.

Abmischungen von Polyarylensulfiden mit Polycarbonaten sind bekannt (z.B. Jp-POS 51-59952, EP-OS 104 543, US-PS 4 021 596.

Für bestimmte Anwendungszwecke ist das Eigenschaftsprofil derartiger Abmischungen jedoch nicht immer ganz befriedigend.

Es wurde nun gefunden, daß Abmischungen von Polyarylensulfiden (PAS), vorzugsweise Polyphenylensulfid (PPS) mit geringen Mengen an organischen Carbonaten und/oder Polyestercarbonaten und/oder Siloxan-copolycarbonaten und Glasfasern und gegebenenfalls weiteren Zusatzstoffen sich durch ihre mechanischen Eigenschaften, z.B. Zähigkeit, Biegefestigkeit, Randfaserdehnung usw. besonders auszeichnen.

Gegenstand der Erfindung sind daher thermoplastische Mischungen aus

A) 95 bis 15 Gew.-%, vorzugsweise
90 bis 15 Gew.-% einer Mischung aus
99.9 bis 75 Gew.-Teilen, vorzugsweise
99.9 bis 85 Gew.-Teilen Polyarylensulfiden, vorzugsweise PPS und
0.1 bis 25 Gew.-Teilen, vorzugsweise
0.1 bis 15 Gew.-Teilen anderen Thermoplasten wie Polyestercarbonaten und/oder organischen Carbonaten und/oder Siloxan-co-polycarbonaten,

B) 5 bis 85 Gew.-%, vorzugsweise
10 bis 85 Gew.-% Glasfasern und,

C) bezogen auf das Gewicht der Summe der Komponenten A + B, gegebenenfalls 0,1 bis 100 Gew.-% anderen mineralischen und/oder nicht mineralischen Zusatzstoffen und/oder üblichen Hilfsstoffen.

Bevorzugte erfindungsgemäße thermoplastische Mischungen bestehen aus

A) 45 bis 75 Gew.-% einer Mischung aus
99,7 bis 90 Gew.-Teilen Polyarylensulfiden, vorzugsweise PPS und
0,3 bis 10 Gew.-Teilen organischen Carbonaten und/oder Polyestercarbonaten und/oder Siloxan-co-polycarbonaten,

B) 55 bis 25 Gew.-% Glasfasern und,

C) bezogen auf das Gewicht der Summe der Komponenten A + B gegebenenfalls 0,1 bis 20 Gew.-% anderen mineralischen und/oder nicht mineralischen Zusatzstoffen und/oder üblichen Hilfsstoffen.

Besonders bevorzugte erfindungsgemäße thermoplastische Mischungen bestehen aus

A) 50 bis 70 Gew.-% einer Mischung aus
99,5 bis 95 Gew.-Teilen Polyarylensulfiden, vorzugsweise PPS und
0,5 bis 5 Gew.-Teilen organischen Carbonaten und/oder Polyestercarbonaten und/oder Siloxan-co-polycarbonaten,

B) 50 bis 30 Gew.-% Glasfasern und,

C) bezogen auf das Gewicht der Summe der Komponenten A + B gegebenenfalls 0.3 bis 10 Gew.-% anderen mineralischen und/oder nicht mineralischen Zusatzstoffen und/oder üblichen Hilfsstoffen.

Erfindungsgemäß verwendbare organische Carbonate wie aromatische und aliphatische und aliphatisch-aromatische monomere Carbonate, Oligocarbonate und Polycarbonate sind bekannt (z.B. H. Schnell, Chemistry and Physics of Polycarbonates, Interscience Publishers, New York 1964) und handelsüblich (z.B. Makrolon®). Sie können ein Molekulargewicht $M_w$ bis zu 200.000 haben.

Die monomeren Carbonate sind z.B. handelsüblich oder können nach bekannten Verfahren analog hergestellt werden. Beispielsweise können monomere aromatische Carbonate wie Diphenylcarbonat, Bis-4,4′-(tert.-Butylphenyl)carbonat, Bis-4,4′-(isooctylphenyl)carbonat, Bis-(dodecylphenyl)carbonat und Umsetzungsprodukte wie sie z.B. durch Reaktion von Diphenolen mit Chloroformiaten von Monophenolen

erhältlich sind, also Bis-arylcarbonate von Diphenolen wie beispielsweise Bis-phenylcarbonat von Bisphenol-A, verwendet werden.

Als monomere aliphatische Carbonate können z.B. offenkettige $C_3$-$C_{18}$-Carbonate, $C_4$-$C_{14}$-cyclische Carbonate und cyclisches Ethylencarbonat verwendet werden usw..

Die oligomeren Carbonate haben Molekulargewichte $\overline{M}w$ bis 10.000, vorzugsweise 9.999.

Die Polycarbonate haben Molekulargewichte $\overline{M}w$ von 10.000 bis 200.000.

Weiterhin können als organische Carbonate erfindungsgemäß auch Si-haltige Oligo- und Polycarbonate, wie beispielsweise in der EP-A-17 44 93 genannt, eingesetzt werden.

Erfindungsgemäß können auch die aus der DE-A-3 347 071 bekannten Siloxan-co-polycarbonate (Polydiorganosiloxan-Polycarbonat-Blockcopolymere) eingesetzt werden. Diese haben in der Polymerkette aromatische Carbonatstruktureinheiten der Formel (I) und Aryloxyendgruppenhaltige Polydiorganosiloxane der Formel (II),

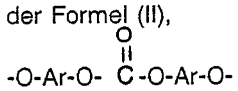 (I),

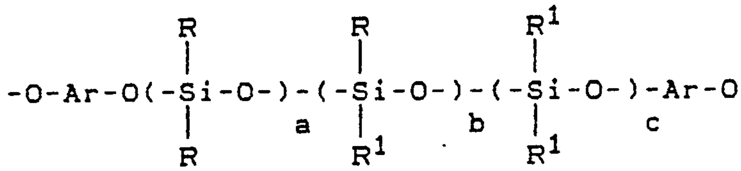 (II),

worin

Ar gleiche oder verschiedene $C_6$-$C_{24}$-Arylenreste sind und

R und $R^1$ gleich oder verschieden sind und gegebenenfalls mit Halogen wie Cl, Br substituiertes $C_1$-$C_{20}$-Alkyl, $C_2$-$C_{20}$-Alkenyl, $C_6$-$C_{24}$-Aryl, bevorzugt Methyl und Phenyl bedeuten

und

die Anzahl der Diorganosiloxy-Einheiten n = (a + b + c) als Summe 5 bis 200, vorzugsweise 10 bis 150, besonders bevorzugt 20 bis 80 ist.

Gut geeignet sind hierbei derartige Polydiorganosiloxan-Polycarbonat-Blockcopolymere, die einen Siloxangehalt bis zu 80 Gew.-% aufweisen, vorzugsweise 5 bis 70 Gew.-%, besonders bevorzugt 30 bis 60 Gew.-%.

Geeignete Polydiorganosiloxan-Polycarbonat-Blockcopolymere haben z.B. mittlere Molgewichte $\overline{M}_w$ von 2000 bis 200.000.

Der Zusatz von Siloxan-co-polycarbonaten kann außerdem zu einer deutlich verbesserten Entformbarkeit führen.

Erfindungsgemäß verwendbare Polyestercarbonate sind bekannt (z.B. DE-A-3 007 934) und handelsüblich, z. B. APEC®.

Erfindungsgemäß werden handelsübliche, gegebenenfalls auf übliche Art geschlichtete Glasfasern eingesetzt. Sie haben einen Durchmesser von 1,5 bis 20 µm, vorzugsweise 5 bis 13 µm. Ihre Länge beträgt 0,05 bis 30 mm, vorzugsweise 1 bis 10 mm. Es können auch Endlosfasern eingesetzt werden und/oder Herstellungsverfahren gewählt werden, bei denen die Länge der Faser in der fertigen Abmischung 0,05 bis 10, bevorzugt 0,1 bis 2 mm beträgt. Es können auch Endlosfasern (Rovings) eingesetzt werden in Verfahren zur Herstellung von endlosfaserverstärktem Unidirektionalverbund.

Gegebenenfalls können auch - insbesondere teilweise -anstelle der Glasfasern handelsübliche Glaskugeln eingesetzt werden, z.B. Ballotini-Glaskugeln; diese können gegebenenfalls auch zusätzlich zu den Glasfasern als weitere mineralische Füllstoffe dienen.

Als weitere, gegebenenfalls mineralische, Füllstoffe oder Zusatzstoffe seien genannt, ohne jedoch dadurch den Erfindungsbereich einschränken zu wollen: Glimmer, Talcum, Quarzmehl, Metalloxide und -sulfide wie $TiO_2$, ZnO, ZnS; Graphit, Ruß, Fasern, z.B. aus Quarz, Kohle u.s.w., Carbonate wie Magnesiumcarbonate, z.B. $MgCO_3$, $CaCO_3$ u.s.w., Sulfate wie $CaSO_4$, $BaSO_4$ usw.

Als weitere, übliche Zusatzstoffe können z.B. übliche Pigmente, Entformungsmittel, E-Wachse, Fließhilfsmittel, Stabilisatoren, Nucleierungsmittel, u.s.w. zugesetzt werden.

Die erfindungsgemäßen Mischungen können auf übliche Art und Weise z.B. durch Extrusion hergestellt werden.

Die erfindungsgemäßen Mischungen können auf übliche Weise zu Formteilen, Halbzeug, Fasern, Folien, Profilen usw. verarbeitet werden. Die erfindungsgemäßen Mischungen können generell in vorteilhafter Weise dort verwendet werden, wo thermoplastisch verarbeitbare Massen eingesetzt werden.

Beispiel 1

Gemischt wurden auf einem Doppelschneckenextruder ZSK 30 von Werner und Pfleiderer bei 320 °C 55 Gew.-Teile PPS mit einer Schmelzviskosität von 60 Pa.s (306 °C, Schubspannung = 1000/sec; hergestellt z.B. nach EP-OS 171 021) mit 45 Gew.-Teilen handelsüblicher geschlichteter Schnittglasfaser (Bayer CS 7916®).

Die Mischung wurde granuliert und zu Prüfstäben (z. B. der Maße 80 x 10 x 4 mm) verspritzt. Diese wurden hinsichtlich Biegefestigkeit, Randfaserdehnung, Biege-E-Modul und Schlagzähigkeit $a_n$ (reversed notched, ISO 180) sowie auf Wärmeformbeständigkeit HDT untersucht.

Beispiele 2, 3

Gemischt wurden wie in Beispiel 1 PPS und Glasfaser gemäß Tabelle 1 und zwar unter Zusatz von Polycarbonat (Makrolon® 5700) der Lösungsviskosität $\eta_{rel} = 1,8$ (gemessen in 0,5%iger Methylenchloridlösung bei 25 °C).

Beispiel 4

Wie in Beispiel 1 wurden gemischt: PPS, Glasfaser, Talkum und basisches $MgCO_3$ sowie E-Wachs gemäß Tabelle 1.

Beispiel 5

Wie in Beispiel 4 wurden PPS, Glasfaser, Talkum, bas. Mg-carbonat und E-Wachs unter Zusatz von Polycarbonat Makrolon® M 5700 gemischt.

Beispiel 6

Handelübliches PPS Tedur® mit 30 % Glasfaser wurde wie in Beispiel 1 reextrudiert und verspritzt.

Beispiel 7

Wie in Beispiel 6 wurde Tedur® (30% glasfaserverstärkt) reextrudiert und zwar unter Zusatz von 1 Gew.-% Makrolon® 5700.

Beispiel 8

Handelsübliches PPS Tedur® (45% glasfaserverstärkt) wurde reextrudiert und verspritzt unter den Bedingungen aus Beispiel 1.

Beispiel 9

Wie in Beispiel 8 wurde Tedur® reextrudiert und zwar unter Zusatz von 1 Gew.% handelsüblichem Polycarbonat Makrolon® M 2808 der Lösungsviskosität $\eta_{rel}$ 1,29 (gemessen in 0,5%iger Methylenchloridlösung bei 25 °C).

Beispiele 10, 11, 12

Gemischt wurden wie in Beispiel 1) PPS und Glasfaser gemäß Tabelle 2, bei Beispielen 11 und 12 unter Zusatz von Diphenylcarbonat.

Beispiel 13

Wie Beispiel 11, 12; jedoch wurde als organisches Carbonat ein nach üblichem Verfahren in Phasengrenzfläche hergestelltes Oligocarbonat ( $\overline{M}w$ 2.500), auf Basis von Bisphenol-A und Phenol, eingesetzt.

Beispiel 14

Wie in Beispiel 10 wurden 60 % PPS und 40 % Glasfaser gemischt. Zusätzlich zu den Prüfstäben wurden Entformungshülsen (40 mm Ø, 35 mm hoch) gespritzt bei einer Massetemperatur von 320° C und einer Formtemperatur von 120° C. Es wurde die zum Entformen erforderliche Kraft als Entformungsdruck gemäß Tabelle 3 hydraulisch bestimmt.

Beispiele 15, 16, 17

Wie in Beispiel 14 wurde PPS mit Glasfaser gemischt und zwar unter Zusatz wechselnder Mengen von 50 Gew.-% Siloxan-Block enthaltendem Copolycarbonat der relativen Lösungsviskosität $\eta_{rel}$ 1,30 (gemessen in 0,5 %iger Dichlormethan-Lösung bei 25° C) gemäß Tabelle 3.

<u>Tabelle 1</u>

PPS-Mischungen und ihre Eigenschaften

| Beispiel Nr. | 1 | 2 | 3 | 4 | 5 |
|---|---|---|---|---|---|
| PPS | 55 | 54 | 50 | 54,3 | 52,3 |
| Glasfaser | 45 | 45 | 45 | 45 | 45 |
| Polycarbonat (Makrolon® 5700) | - | 1 | 5 | - | 2 |
| (Makrolon® 2808) | - | - | - | - | - |
| E-Wachs | - | - | - | 0,2 | 0,2 |
| $MgCO_3$ basisch | - | - | - | 0,5 | 0,5 |
| Tedur® (45 % Glasfaser) | - | - | - | - | - |
| Tedur® (30 % Glasfaser) | - | - | - | - | - |
| Biegefestigkeit (ISO 178) MPa | 261 | 288 | 253 | 191 | 270 |
| Randfaserdehnung % | 1,7 | 1,8 | 1,6 | 1,3 | 1,7 |
| Biege E-Modul (DIN 53457) MPa | 15800 | 15900 | 15400 | 15900 | 16600 |
| Schlagzähigkeit $a_n$ $kJ/m^2$ | 32 | 36 | 30 | 26 | 30 |
| HDT 0,2% Randfaserdehnung (ISO 75/A) °C | 268 | 267 | 260 | - | 267 |

Tabelle 1 (Fortsetzung)

PPS-Mischungen und ihre Eigenschaften

| Beispiel Nr. | | 6 | 7 | 8 | 9 |
|---|---|---|---|---|---|
| PPS | | - | - | - | - |
| Glasfaser | | - | - | - | - |
| Polycarbonat (Makrolon® 5700) | | - | 1 | - | - |
| (Makrolon® 2808) | | - | - | - | 1 |
| E-Wachs | | - | - | - | |
| $MgCO_3$ basisch | | - | - | - | - |
| Tedur® (45 % Glasfaser) | | - | - | 100 | 99 |
| Tedur® (30 % Glasfaser) | | 100 | 99 | - | - |
| Biegefestigkeit (ISO 178) | MPa | 223 | 247 | 243 | 281 |
| Randfaserdehnung | % | 2,1 | 2,3 | 1,6 | 1,8 |
| Biege E-Modul (DIN 53457) | MPa | 11100 | 11200 | 16600 | 16800 |
| Schlagzähigkeit $a_n$ | $kJ/m^2$ | 33 | 34 | 31 | 35 |
| HDT 0,2% Randfaserdehnung (ISO 75/A) | °C | - | - | - | - |

Tabelle 2

| PPS-Mischungen und ihre Eigenschaften | | | | | |
|---|---|---|---|---|---|
| Beispiel Nr. | | 10 | 11 | 12 | 13 |
| PPS | | 60 | 59 | 58 | 58,5 |
| Glasfaser | | 40 | 40 | 40 | 40 |
| Diphenylcarbonat | | - | 1 | 2 | - |
| Oligocarbonat | | - | - | - | 1,5 |
| Biegefestigkeit (ISO 178) | MPa | 258 | 267 | 285 | 280 |
| Randfaserdehnung | % | 1,9 | 2,0 | 2,1 | 2,1 |
| Schlagzähigkeit $a_n$ | $kJ/m^2$ | 35 | 37 | 39 | 40 |

Die Angaben bezüglich der Zusammensetzungen in den Beispielen 1 bis 17 in Tabellen 1, 2 und 3 sind Gew.-Teile.

Tabelle 3

| PPS-Mischungen und ihre Eigenschaften | | | | | |
|---|---|---|---|---|---|
| Beispiel Nr. | | 14 | 15 | 16 | 17 |
| PPS | | 60 | 59 | 57 | 55 |
| Glasfaser | | 40 | 40 | 40 | 40 |
| Siloxan-co-polycarbonat [a)] | | - | 1 | 3 | 5 |
| Biegefestigkeit (SO 178) | MPa | 260 | 280 | 290 | 285 |
| Randfaserdehnung | % | 1,9 | 2,1 | 2,3 | 2,4 |
| Schlagzähigkeit $a_n$ | $kJ/m^2$ | 37 | 41 | 47 | 50 |
| Entformungsdruck | bar | 70 | 30 | 12 | n.b.[b)] |

[a)] eingesetzt wurde ein Siloxan-co-polycarbonat mit 50 Gew.-% Polydimethylsiloxaneinheiten mit einer mittleren Blocklänge von n = 60 und 50 Gew.-% vom Bisphenol-A abgeleiteten Polycarbonateinheiten. as Siloxan-co-polycarbonat hat eine relative Lösungsviskosität $\eta_{rel}$ = 1,3 (in 0,5 %iger Dichlormethanlösung bei 25 °C).

[b)] n.b. = nicht bestimmt

## Ansprüche

1. Thermoplastische Mischungen aus
A) 95 bis 15 Gew.-%, vorzugsweise
90 bis 15 Gew.-% einer Mischung aus
99.9 bis 75 Gew.-Teilen, vorzugsweise
99.9 bis 85 Gew.-Teilen Polyarylensulfiden, vorzugsweise PPS und
0.1 bis 25 Gew.-Teilen, vorzugsweise
0.1 bis 15 Gew.-Teilen anderen Thermoplasten wie Polyestercarbonaten und/oder organischer Carbonaten und/oder Siloxan-co-polycarbonaten,
B) 5 bis 85 Gew.-%, vorzugsweise
10 bis 85 Gew.-% Glasfasern und,
C) bezogen auf das Gewicht der Summe der Komponenten A + B, gegebenenfalls 0,1 bis 100 Gew.-% anderen mineralischen und/oder nicht mineralischen Zusatzstoffen und/oder üblichen Hilfsstoffen.

2. Thermoplastische Mischungen bestehend aus

A) 45 bis 75 Gew.-% einer Mischung aus
99,7 bis 90 Gew.-Teilen Polyarylensulfiden, vorzugsweise PPS, und
0,3 bis 10 Gew-Teilen organischen Carbonaten und/oder Polyestercarbonaten und/oder Siloxan-co-polycarbonaten,
B) 55 bis 25 Gew.-% Glasfasern und,
C) bezogen auf das Gewicht der Summe der Komponenten A + B, gegebenenfalls 0.1 bis 20 Gew.-% anderen mineralischen und/oder nicht mineralischen Zusatzstoffen und/oder üblichen Hilfsstoffen.

3. Thermoplastische Mischungen bestehend aus
A) 50 bis 70 Gew.-% einer Mischung aus
99,5 bis 95 Gew.-Teilen Polyarylensulfiden, vorzugsweise PPS und
0,5 bis 5 Gew.-Teilen organischen Carbonaten und/oder Polyestercarbonaten und/oder Siloxan-co-polycarbonaten,
B) 50 bis 30 Gew.-% Glasfasern und,
C) bezogen auf das Gewicht der Summe der Komponenten A + B gegebenenfalls 0,3 bis 10 Gew.-% anderen mineralischen und/oder nicht mineralischen Zusatzstoffen und/oder üblichen Hilfsstoffen.

4. Verwendung von Mischungen gemäß Anspruch 1 zur Herstellung von Formkörpern, Halbzeug, Fasern, Folien und Profile.